(19) Europäisches Patentamt
European Patent Office
Office européen des brevets

(11) **EP 2 375 496 A1**

(12) **EUROPEAN PATENT APPLICATION**

(43) Date of publication:
**12.10.2011 Bulletin 2011/41**

(51) Int Cl.:
*H01Q 15/00* *(2006.01)*   *H01Q 17/00* *(2006.01)*
*H05K 9/00* *(2006.01)*

(21) Application number: **10003849.6**

(22) Date of filing: **12.04.2010**

| (84) Designated Contracting States:<br>**AT BE BG CH CY CZ DE DK EE ES FI FR GB GR HR HU IE IS IT LI LT LU LV MC MK MT NL NO PL PT RO SE SI SK SM TR**<br>Designated Extension States:<br>**AL BA ME RS** | (71) Applicant: **ETH Zurich**<br>**8092 Zürich (CH)**<br><br>(72) Inventors:<br>• **Hafner, Christian**<br>  **8037 Zürich (CH)**<br>• **Fallahi, Arya**<br>  **8032 Zürich (CH)** |
| --- | --- |

(54) **Absorber for electromagnetic radiation**

(57) The absorber comprises a lossy substrate (1) with a first, structured metallic layer (4) and a second, non-structured metallic layer (6) arranged on opposite surfaces (3, 5). An additional carrier layer (10) can be provided for mechanically supporting the first metallic layer (4). The substrate (1) is perforated by openings (2) and/or is provided with recesses. Methods are described for optimizing the structure of the first metallic layer (4) as well as of the openings (2) or recesses. The combination of the structured first metallic layer (4) and the openings (2) or recesses allows to provide an absorber with improved absorption properties.

Fig. 3

**Description**

Technical Field

The invention relates to an absorber for electromagnetic radiation as well as to a method for manufacturing such an absorber.

Background Art

Absorbers for electromagnetic radiation, known as radar absorbers, are usually layers that cover a device and minimize the reflection of incident electromagnetic waves. They have attracted much interest due to numerous applications in different domains [1]. In tracking applications and the so-called stealth technology, radar absorbers can be used to reduce the radar cross section (RCS) of an object [2]. They are also of interest for shielding electronic circuits and equipments protecting living beings from electromagnetic radiation. In electromagnetic measurement systems, absorbers are indispensable to obtain reliable results. Measurements of electromagnetic compatibility (EMC) and antenna radiation patterns require that spurious signals arising from the test setup and reflections are negligible. This necessitates carrying out the measurements in anechoic chambers.

One of the most effective types of radar absorbers comprises arrays of pyramid shaped pieces made out of a lossy material. [1]-[4]. An alternative type comprises flat plates of ferrite material in the form of flat tiles fixed to all interior surfaces of the chamber [5]. Another approach for making absorbers is taking advantage of Salisbury screens which is mainly a resistive sheet in the distance of $\lambda_0/4$ from a ground plane [6]. These kinds of absorbers are usually narrow band devices and they are quite bulky for operating in lower frequencies [7]. Based on analogous principles, Jaumann absorbers were developed, which are in principle multilayer structures designed to absorb radiation with broader bandwidth [8]. However, these absorbers still suffer from large thickness.

With the appearance of the metamaterial concept, some new absorbers based on frequency selective surfaces ($FSS_S$) have been proposed [9]. The FSS absorbers consist of a lossy substrate having a grounded metallic layer on the one side and being covered with a periodically structured metallic layer (patch layer) on the other side [10],[11]. At some frequencies, the patch layer exhibits resonance and, due to the loss of the substrate, high absorption of the incident field is obtained. These absorbers are usually much thinner than those mentioned above. Nonetheless, since the operation is based on resonance effects, they still suffer from narrow bandwidths. One way to tackle this problem is using optimizers to find an optimum bandwidth [12].

Since planar periodic material blocks can also exhibit frequency selective properties, electromagnetic absorbers based on textured substrates have been proposed. In [13], an optimization scheme is applied to obtain the best configuration of the textured substrate. Despite the strong improvement in the bandwidth, the resulting substrates are not easily manufacturable. The reason is mainly the need for an intricate texturizing of the substrate in each unit cell.

Recently, it was shown that the properties of an absorber can be modified when periodic inhomogeneities are incorporated in the substrate [14].

Disclosure of the Invention

The problem to be solved by the present invention is therefore to provide an alternative absorber of this type that has potentially good absorptive properties.

This problem is solved by the absorber of claim 1. Accordingly, the absorber comprises a lossy substrate, a first, structured metallic layer arranged on a first side of the substrate and a second metallic layer arranged on a second side of the substrate. In addition, a plurality of holes in the form of openings or recesses is arranged in the substrate.

This design has the advantage that the openings or recesses in the substrate affect the resonance properties of the structured metallic layer and the spectral absorption of the whole device. Hence, the presence of the openings or recesses in the substrate allows broadening the spectral response of the absorber.

Another advantage lies in the fact that a simple structure can be used in the substrate, while the first metallic layer can be structured in more complex manner. Since the substrate is typically perforated or recessed using mechanical methods (such as drilling or punching), a simple structure for the recesses is able to enhance the properties considerably.

Advantageously, and in order to simplify production, openings extending through the substrate, are used. If recesses are used, such recesses advantageously extend from the first side (i.e. the side of the structured metallic layer) into the substrate thus that they have an influence on the resonant properties of the structured first metallic layer. However, manufacturing the recesses requires an accurately controlled process for drilling the substrate and consequently adds to the fabrication cost.

In a particularly advantageous embodiment, the absorber further comprises a lossless carrier layer, wherein the first metallic layer is arranged on a surface of this carrier layer. Such a carrier layer mechanically stabilizes the first metallic layer, in particular at the locations of the recesses or openings of the substrate. In addition, it further simplifies the total fabrication process.

The invention also relates to a method for manufacturing such an absorber. Such a method comprises the steps of

providing the substrate,

mounting the first metallic layer to the substrate, and

mounting the second metallic layer to the substrate.

Advantageously, as mentioned above, the absorber comprises a lossless carrier layer, with the first (structured) metallic layer arranged on a surface thereof. This design provides mechanical support for the first metallic layer where it extends over the openings or recesses of the substrate. When manufacturing this type of absorber, the metallic layer is advantageously mounted to a surface of the carrier layer and then the carrier layer and the first metallic layer are mounted to the substrate. In that case, the carrier layer provides mechanical support for the first metallic layer during the manufacturing process.

Other advantageous embodiments are listed in the dependent claims as well as in the description below.

Brief Description of the Drawings

The invention will be better understood and objects other than those set forth above will become apparent from the following detailed description thereof. Such description makes reference to the annexed drawings, wherein:

Fig. 1 is a sectional view of a first absorber,

Fig. 2 shows (a) a parameterization scheme for a unit cell of the structured first metallic layer, (b) a parameterization scheme for the openings or recesses in a unit cell with several openings or recesses, and (c) two possible arrangements of openings or recesses for a unit cell with a single opening or recess,

Fig. 3 is (a) a sectional view of a second absorber and (b) of a third absorber,

Fig. 4 are graphs of (a), (b) the complex relative permittivity $\varepsilon$ and (c), (d) the complex relative permeability $\mu$ of a lossy substrate material,

Fig. 5 schematically illustrates the measurement setup for characterizing the absorbers,

Fig. 6 shows the reflection as a function of frequency for a homogeneous lossy substrate with ground plane on one side,

Fig. 7 shows the reflection coefficient as calculated for an absorber according to the last row of Table I,

Fig. 8 shows (a) the geometry of a unit cell, (b) the reflection as a function of frequency and (c) the reflection as a function of angle for an absorber with homogeneous, non-perforated substrate, and

Fig. 9 shows (a) the geometry of the first metallic layer of a unit cell, (b) the geometry of the openings or recesses in the unit cell, (c) the reflection as a function of frequency and (d) the reflection as a function of angle for an absorber with perforated substrate.

Modes for Carrying Out the Invention

In the following, some terms used in the description and claims are defined in more detail. Then, the basic geometry of an absorber is described in Section 1. In Section II, a design procedure for such an absorber is described. Section III discusses a possible fabrication process and the measurement setup. The resulting absorbers are presented in Section IV. Some final notes are added in Section V.

Definitions:

The term "lossy substrate" refers to a substrate whose complex relative permittivity $\varepsilon = \varepsilon' - i.\varepsilon''$ and complex relative permeability $\mu = \mu' - i\cdot\mu''$ have non-zero imaginary components. Advantageously, the permittivity and permeability are such that

$$1 > (\varepsilon'' \cdot \mu'') / (\varepsilon' \cdot \mu') > 10^{-2}.$$

This relation ensures that the lossy substrate is sufficiently lossy in order to substantially broaden the resonances of the metallic structures without damping them excessively.

A "lossless" layer, on the other hand, refers to a layer where

$$(\varepsilon'' \cdot \mu'')\,/\,(\varepsilon' \cdot \mu') < 10^{-4}$$

## I. Basic Absorber Structure

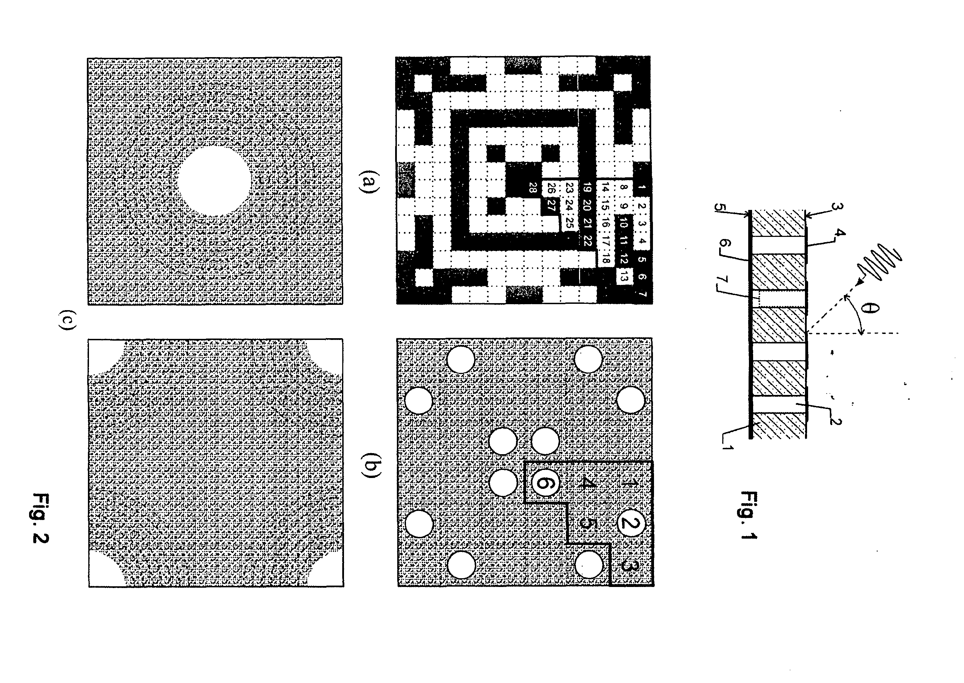

Fig. 1 shows an absorber having a substrate 1 of a lossy material. Substrate I is planar and has a width and length much larger than its thickness. Openings or recesses 2 are arranged in substrate 1. On a first side 3 of substrate 1, a structured metallic layer 4 is provided, and on a second side 5 a typically unstructured (i.e. continuous, without any openings) and grounded second metallic layer 6 is mounted.

Lossy substrate 1 is advantageously of a slightly conducting material having a relative permittivity $\varepsilon$ and relative permeability $\mu$ in the range defined above. It is e.g. a conducting polymer or a semiconductor. It is typically not a metal because the imaginary parts of the electric permittivity $\varepsilon$ of a metal are generally too high.

In the embodiment of Fig. 1, openings 2 extending all the way through the substrate I are used. As mentioned above, instead or in addition thereto, recesses (as denoted in dotted lines 7) could be used as well.

The recesses 7 or openings 2 can be empty or they can be filled with a gas or with any other lossless material. However, it is better not to fill with lossy materials since they may reduce the strength of the resonance in the substrate.

To simplify the manufacturing process, the recesses or openings 2 in substrate 1 are advantageously arranged at regular intervals.

In a particularly advantageous embodiment, the recesses or openings 2 have circular cross section, which simplifies the manufacturing process.

Also for manufacturing reasons as well as in order to simplify mathematical modelling, first metallic layer 4 has a lattice structure which is periodic along the two dimensions of the surfaces of substrate 1 with a geometry built up from identical lattice unit cells, with each unit cell covering an identical arrangement of recesses or openings 2.

A typical periodicity (i.e. the unit cell width and height) is in the order of $c/f_{max}$, with c being the speed of light and $f_{max}$ a maximum desired absorption frequency of the absorber. For $f_{max}$ being 30 GHz, the size of the unit cells is e.g. 1 cm $\times$ 1 cm.

Advantageously, each unit cell has mirror symmetry with respect to the directions $x$ and $y$ withe and $y$ being two directions parallel to the surface of absorber 1 and $y$ being perpendicular to $x$. In addition, each unit cell has mirror symmetry with respect to the bisectrix of x and y. This results in a substantially isotropic response of the spectral reflectance under 90˚ rotations of the absorber about an axis perpendicular to its surface.

## II. Methodology

In structures of the type described above, there are numerous scatterers arranged periodically in a host medium, which gives rise to multiple scattering effects. Furthermore, when the periodicity is of the order of a wavelength, the well-known homogenization techniques fail and the field behavior becomes more sophisticated. Because of the complexity of the effects, one cannot design such structures based on physical intuition. Therefore, the design of absorbers based on homogeneous or perforated substrates is advantageously carried out using appropriate optimization algorithms.

There are four main steps in the design of a planar absorber: First, an electromagnetic field analysis method is selected and tailored to efficiently analyze and evaluate all possible solutions. Second, an optimization algorithm should be chosen, which is able to efficiently find optimum structures in a fitness evaluation. Third, the optimization domain is defined, and finally a proper fitness function for the particular application must be defined. After fulfilling these tasks, optimizations are run to produce structures, which are expected to perform optimally. In the following, each of the above steps as well as their results are discussed.

## II.A Analysis Method

Fitness evaluation is carried out on an absorber as shown in Fig. 1 and described in Section I. The problem is to calculate the power reflection coefficient when a plane wave illuminates the planar structure with various frequencies, incidence angles and polarizations.

The goal of the design of radar absorbers is to obtain very small values of the reflection coefficient. Because of numerical cancelations in the computation of small values, a high accuracy of the analysis method is advantageous. Additionally, the method should be efficient enough to make numerical optimizations possible. The periodic method of moments meets the above requirements [15] for the analysis of FSS structures on unperforated substrates. In order to handle the perforations, it is combined with the transmission line method (MoM/TL) [14]. There are two choices for the MoM basis functions, namely rooftop [16] and entire domain basis functions [17]. Because of the existence of several patches (metallic regions) in the unit cell, using entire domain basis functions results in high computation costs. Therefore, rooftop basis functions are the superior choice for our purpose. To decrease the number of frequency points in the analysis, model based parameter estimation (MBPE) is used to efficiently obtain the reflection spectrum [ 18].

II.B Optimization Algorithm

In [19], a thorough and detailed study is carried out to find an optimization algorithm that is well suited for FSS problems. It was demonstrated that a binary hill climbing (RHC) algorithm with random initialization and random restart outperforms well-known stochastic optimizers - such as genetic algorithms and evolutionary strategies - in both the probability of finding the global optimum and the number of required fitness evaluations for obtaining sufficiently good sub-optimal solutions. The RHC algorithm may be described as follows:

(1) Perform random initialization and fitness evaluation of the first generation with $N_{pop}$ individuals. (2) Perform bit-fitness value evaluation. (3) Select the best individual (strict elitism) as the parent for the next generation with $N$ (length of the bit string) indivduals. (4) Generate child number n by flipping bit number n of the parent. (5) Repeat step 2 until the parent is better than all of its $N$ children. When this happens, (6) reinitialize the first population using bit fitness proportional (BFP) mutation and continue with step 2 until the stopping criterion is met.

In this study, the algorithm with $N_{pop}$ = 2 is employed and stopped when the number of fitness evaluation exceeds 5000. This stopping criterion avoids long computation times but it does not guarantee that the global optimum is reached. However, it is sufficient for finding very promising solutions.

II.C Optimization Domain

The remaining two steps, i.e. definition of the optimization domain and the fitness functions directly depend on the specific absorber to be manufactured. Therefore, the goal of the design should first be set and the above aspects are defined accordingly. Here, a thin, planar absorber which has an optimum bandwidth and angular stability within the intervals 0 GHz < f < 30 GHz and 0˚ < θ < 90˚ is to be obtained. As usual for the absorbers, similar characteristics for θ and -θ (mirror symmetry) as well as $x$ and $y$ directions (azimuthal symmetry) are desired, with $x$ and $y$ denoting two orthogonal directions parallel to first surface 3 of substrate 1.

First of all, we assume that the thickness of the substrate is fixed and needs no optimization. The reasons are the interest in thin radar absorbers, which delimits the thickness to small values, and the commercial availability of substrates with certain thicknesses. In addition, to prevent propagation of high order diffraction modes, the periodicity of the substrate is fixed, based on the desired operation frequency. Thus, the lattice constant for the periodic structure is presumed to be 1 cm.

To optimize the FSS patch unit cell configuration, it is subdivided to 14 $\times$ 14 pixels on a regular grid. The optimizer then decides whether a pixel contains a metallic layer or not. Therefore, the patch unit cell is easily encoded into a bit string with 14 $\times$ 14 bits. However, due to symmetry consideration only a fraction of the whole pixels need to be coded and the other ones are obtained from symmetry operations. Fig. 2(a) illustrates these pixels. As shown in the figure, a bit string with 28 bits encodes the whole patch unit cell. Since we decided to keep substrate thickness and periodicity constant, there is no variable regarding the substrate that should be optimized, as long as no perforations of the substrate are considered. Thus, the optimization domain is fully defined by a bit string of 28 bits. As a consequence of the considered subdivision and symmetries, the Fourier series in the MoM analysis should be truncated at M = $\pm$14. This leads to a computation time of 0.6 sec to calculate the reflected power in 30 frequency points for normal incidence and an additional 2 sec for oblique incidence in 8 incidence angles for both polarizations. The corresponding code is written in MATLAB and run on a 8$\times$ AMD Opteron Processor 2384 @2.71 GHz with a Linux platform.

The recesses or openings 2 in substrate 1 need to be optimized as well. For the following, it is assumed that they are in the form of openings extending all the way through substrate 1, even though similar computational methods can be used for modelling recesses as well. Further, it is assumed that the openings are in the form of circular cylindrical holes in order to be easily manufactured. Second, the holes are not manufactured so easily as the patch layer. Therefore, a low number of holes per unit cell area is desirable. One way is to analogously subdivide the substrate unit cell by a grid and encode it with a second bit string, in which one indicates the existence of a hole in the pixel center. To avoid a large number of holes, a 6 $\times$ 6 grid is considered in our study (a string of 6 bits) and the hole diameters are fixed to 1 mm (Fig. 2(b)). Another approach is to assume only one hole per unit cell and optimize its radius and position. Due to the symmetry constraints, the position can be either in the center or on the corners of the unit cell. This is encoded by 1 bit and the radius is chosen by the optimizer among a discrete set of values, namely $r \in$ {0.5, 1, 1.5, 2, 2.5, 3, 3.5, 4} mm (Fig. 2(c)). As will be shown, the second approach is the superior choice because-it leads to better results. It should be mentioned that there is room for refinement of the optimization of both types of perforations. In principle, one might combine and generalize these approaches by considering several perforations with diameters and locations to be optimized. This could provide better radar absorbers, but it leads to large bit strings and long computation times and finally to a more demanding manufacturing process.

In the analysis of the absorber with periodic substrate, again the same Fourier series truncation order is considered. The computation time for the normal incidence on the same computer as before is about 83 sec in 30 frequency points. For the oblique incidence, an additional 200 sec will be needed to calculate the reflected energy for 8 incidence angles and both TE and TM polarizations.

II.D Fitness Function

After defining the optimization domain, fitness functions should be defined to run the optimizers. Their definition should properly contain the goal of the design. As mentioned before, a radar absorber with optimum bandwidth (BW) and angular stability (AS) is desired. Concerning the first target the following fitness function may be considered:

$$f_\omega = \frac{\Delta f}{30\text{GHz}} \qquad\qquad (1)$$

where $\Delta f$ is the frequency interval (in GHz) over which the power reflection coefficient is less than a certain value, namely $R_l$. An appropriate fitness function for the angular stability is similarly defined as follows:

$$f_\theta = \frac{\Delta \theta}{90°} \qquad\qquad (2)$$

where $\Delta\theta) = \theta_{max} - 0$ is the angle interval (in degrees) with the power reflection coefficient for both polarizations less than $R_l$. In order to save computation time, this interval only is computed for the frequency with maximum absorption.
The challenging part is to define a compound function that maximizes the above criteria properly. A simple possibility is to define a weighted sum of the above function. However, this may incur one function to have a large value and the other one to have a value even below an acceptable limit. For example, the bandwidth which is the most important measure of an absorber may decrease drastically. In this work, the following function is considered for the optimizations,

$$f = (\arctan\left(\frac{100(f_{\omega N} - 0.9)}{\pi}\right) + 0.5)(f_{\omega N} + f_{\theta N}) \qquad (3)$$

with the normalized functions defined as

$$f_{\omega N} = f_\omega / f_{\omega\,\max} \quad \text{and} \quad f_{\theta N} = f_\theta / f_{\theta\,\max} \quad (4)$$

where $f_{\omega\,\max}$ and $f_{\theta\,\max}$ are maximum of $f_\omega$ and $f_\theta$ obtained by the optimizer. The second term in $f$ is simply the addition of the normalized functions. The first term gives a large weight to the cases with bandwidths of more than 90% of the maximum bandwidth and a low weight to the ones with narrower bandwidths.
Employing the **arctan** function or any similar continuous function is advantageous since an abrupt change at bandwidth limit may preclude the optimizer from converging to the optimum.
Consequently, the optimization process begins with running the optimizer for each of the definitions (1) and (2). This returns $f_{\omega\max}$ and $f_{\theta\max}$ as the result. Subsequently, the optimizer is run again for the compound function. To assist the optimizer to find the optimum faster, one can use the results of the previous runs as initial guesses for the last one.

III. Specific Embodiments, Fabrication and Measurement

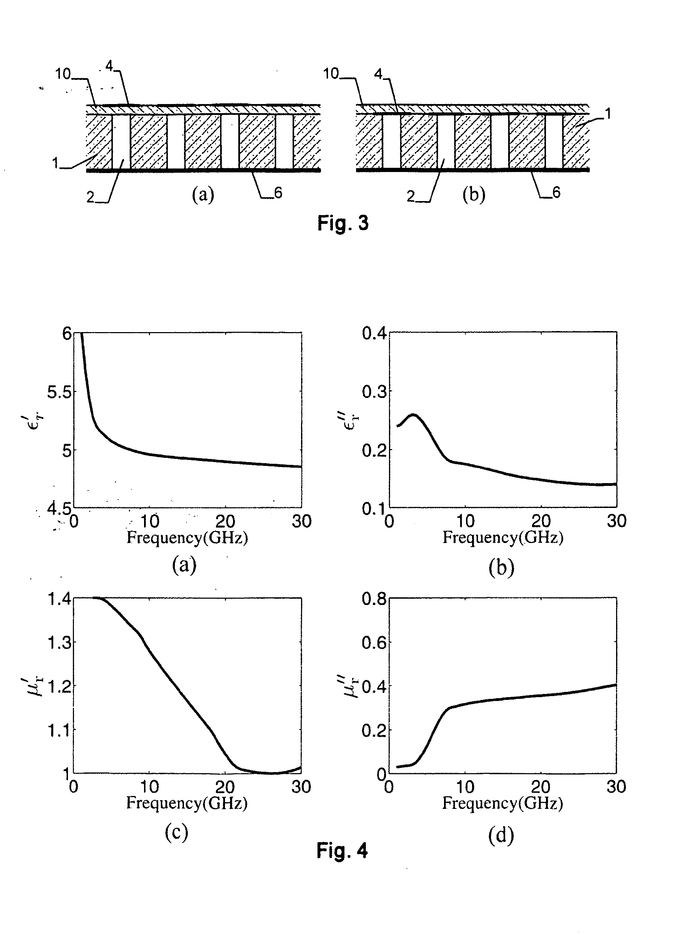

Before the design results are presented, some points about the fabrication process and measurement system are worth being mentioned. As emphasized previously, a lossy substrate should be used. Unfortunately, there exists no appropriate substrate on the market, which is both lossy and have a printed copper layer, which could be used for etching the absorber. Fabricating and pasting the structured first metallic layer 4 on a lossy, perforated substrate 1 would lead to a cumbersome process. Therefore, it is advantageous to mount the first metallic layer 4 on a lossless carrier layer 10, as shown in Fig. 3(a), and then mount carrier layer 10 on lossy substrate 1.

In particular, first metallic layer 4 can be applied to carrier layer 10 before metallic layer 4 is structured. Then, metallic layer 4 is structured, e.g. by covering it with an etch mask, e.g. using photolithographic or printing techniques. Etching is then used to structure metallic layer 4.

The recesses or openings 2 in substrate 1 are advantageously formed prior to mounting carrier layer 10 and first metallic layer 4 to substrate 1, thereby simplifying the manufacturing process for substrate 1.

It must be noted that the optimized absorber is operating based on resonance effects. Thus, inserting a carrier layer 10 in between the first metallic layer 4 and lossy substrate 1, such as shown in Fig. 3(a), can deteriorate the performance drastically. A solution is to paste carrier layer 10 and first metallic layer 4 in upside-down orientation on lossy substrate 1, i.e., in such a way that first metallic layer 4 is arranged between carrier layer 10 and substrate 1, as shown in Fig. 3(b).

The thickness of carrier layer 10 is advantageously at least 100 $\mu$m (depending on the operation wavelength) such that it has good mechanical stability for supporting first metallic layer 4 and in addition it is thin enough to have a negligible effect on the whole performance.

In a specific embodiment, carrier layer 10 is a lossless RT/Duroid 5880 5mil substrate ($\varepsilon_r$ = 2.2). Lossy substrate 1 is the MF-112 absorber material from the ECCOSORB® MF series with thickness 1.87mm. A measurement was carried out for obtaining the complex relative permittivity $\varepsilon$ and relative permeability of the material. The results of this measurement are shown in Fig. 4.

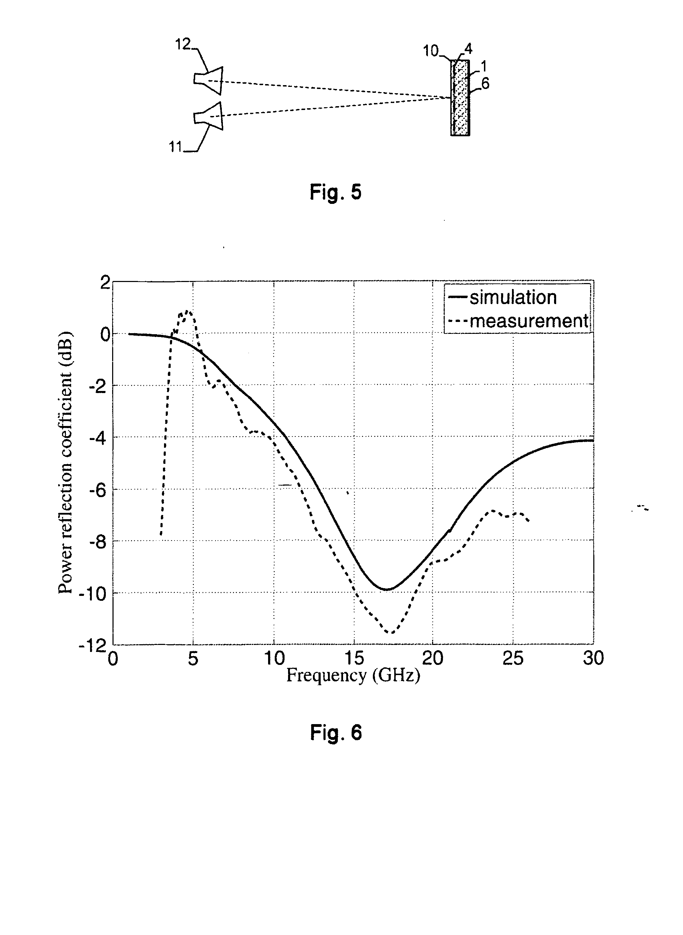

Fig. 5 schematically illustrates the measurement setup for characterizing the absorbers. The manufactured absorber is placed in front of two horn antennas 11, 12, which are located very close to each other and far from the absorber. Since the experiment is carried out in an anechoic chamber, the two antennas are communicating only through the absorber. The transmitted energy between the two antennas is measured once with the absorber and then with a perfect electric conductor (PEC) plane of the same size. Subtracting the obtained two values extracts the reflected energy from the absorber under test. Using a time-gating concept [22], the effects of other scatterers in the setup like the holder and antenna legs are eliminated.

IV. Resulting absorbers

To demonstrate the benefits of the absorbers, first the absorption properties of a homogeneous layer with a ground plane on one side is illustrated in Fig. 6. In this figure, the power reflection coefficient is sketched in terms of the frequency for normal incidence of a plane wave. As seen from the curve, the maximum absorption achieved by this absorber is 12 dB. Note that the antenna and its feeding system fail to perform well at low frequencies. Thus the measurement results at low frequencies are not reliable. Moreover, there are some sources of errors in the measurement procedure which lead to the observed discrepancies in Fig. 6. For instance, diffraction from the edges, errors in the measurement of dielectric and magnetic constants using NRW technique, and the small incidence angle in the setup are some of these sources.

The results obtained by the optimizers are tabulated in Table I.

TABLE I

| THE OPTIMIZATION RESULTS FOR DIFFERENT ABSORBER STRUCTURES | | | | | |
|---|---|---|---|---|---|
| | | | | $f_{max}$ | |
| Subtrate | $R_l$ | $\dfrac{\mathrm{BW_{max}}}{30\,\mathrm{GHz}}$ | $\dfrac{\mathrm{AS_{max}}}{90^\circ}$ | $\left(\dfrac{\mathrm{BW}}{30\,\mathrm{GHz}}\right)$ | $\left(\dfrac{\mathrm{AS}}{90^\circ}\right)$ |
| homogeneous | 15 dB | 0.22 | 0.60 | 0.22 | 0.54 |
| | 20 dB | 0.09 | 0.50 | 0.09 | 0.35 |
| periodic 6 × 6 grid | 15 dB | 0.36 | 0.63 | 0.36 | 0.52 |
| | 20 dB | 0.20 | 0.55 | 0.20 | 0.4 |
| periodic one hole | 15 dB | 0.50 | 0.74 | 0.50 | 053 |
| | 20 dB | 0.37 | 0.54 | 037 | 0.19 |

The RHC optimizer is run for the three unit cell configurations shown in Fig. 2. Two different values of $R_l$, namely 15 dB and 20 dB, in the fitness functions $f_\omega$ (BW$_{max}$), $f_\theta$ (AS$_{max}$) and $f$ are assumed. Since listing the values of $f$ may

not be meaningful, the corresponding values of $f_\omega$ and $f_0$ that result in the maximum value of $f$ are presented.

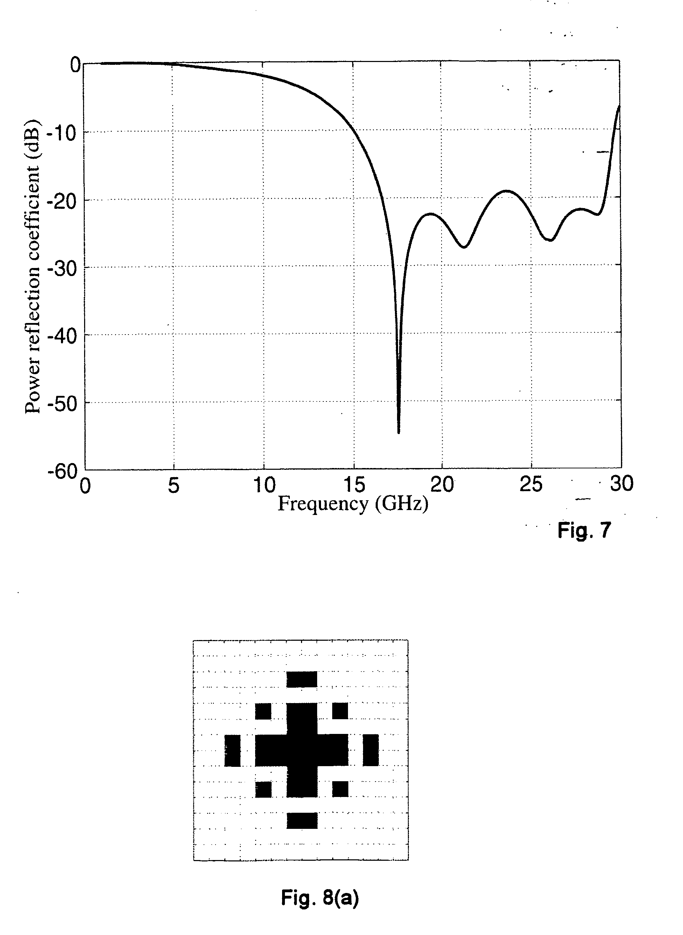

The first conclusion from Table I is the influence of a structured first metallic layer 4 in increasing both the absorption and its bandwidth. Furthermore, the optimization results impart that using a periodically perforated or recessed substrate I can strongly improve the absorber performance. Both maximum bandwidth and maximum angular stability are enhanced. For the combined fitness function, except in the case with one opening in the substrate and $R_l$ = 20 dB (last row), a similar effect is observed. The reason for the results in the last row lies in the failure of the fitness definition. The maximum absorption for the optimum result occurs at a frequency very close to the bandwidth edge, as shown in Fig. 7. Hence, the angular stability computed at this frequency is low compared to the other ones. This confirms the critical role of the fitness definition in the optimization. A better fitness definition - which might result in longer computation times - should result in structures with better angular stability. For instance, if the angular stability would be calculated at the center frequency or averaged over different frequencies, this problem might be solved. Of course, the fitness definition is highly determined by the particular application for which the absorber is designed.

Using several openings or recesses per unit cells enables one to design with more degrees of freedom, which leads to longer computation times. First results reveal that using one recess or opening 2 per unit cell in substrate 1 leads not only to a simpler fabrication process, but also to a better performance. The reason of this effect is understood by studying the reflection curves of each absorber. As will be seen, the main cause of the bandwidth improvement is the additional resonance points introduced by the periodic substrate. Relatively large openings are required for introducing additional resonances, which allow one to broaden the bandwidth. The openings in the multi-hole example are too small for this purpose. This shows that one does not necessarily find better solutions by adding more degrees of freedom, i.e., additional optimization parameters. At the same time, one cannot simply conclude that a single opening per unit cell is optimal for all applications. For example, one might obtain even better solutions by introducing four relatively large holes per unit cell and by optimizing positions as well as locations. However, such configurations would make the fabrication more difficult.

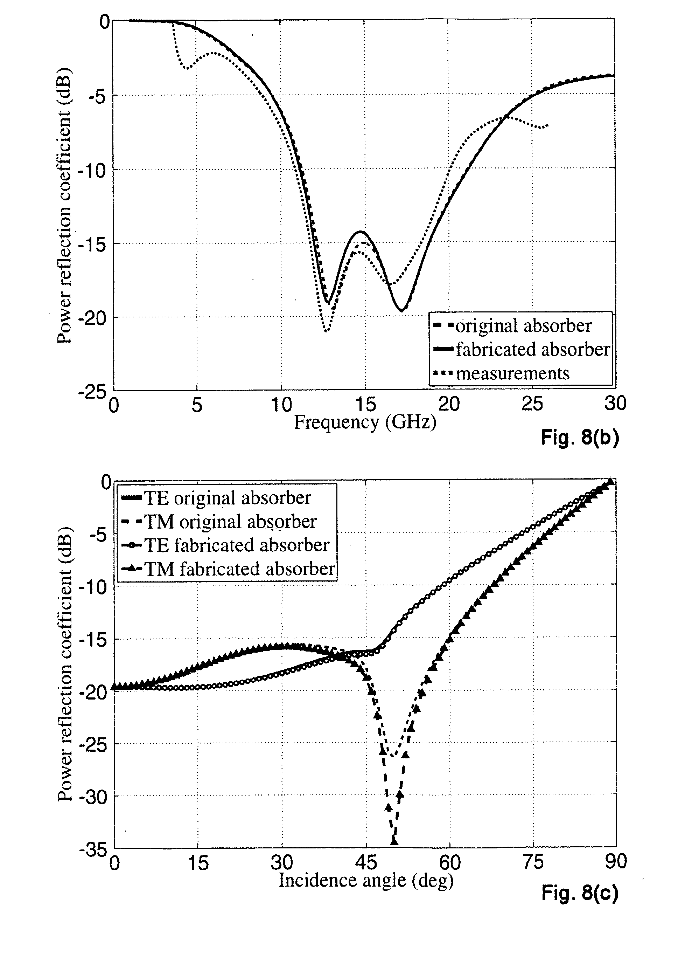

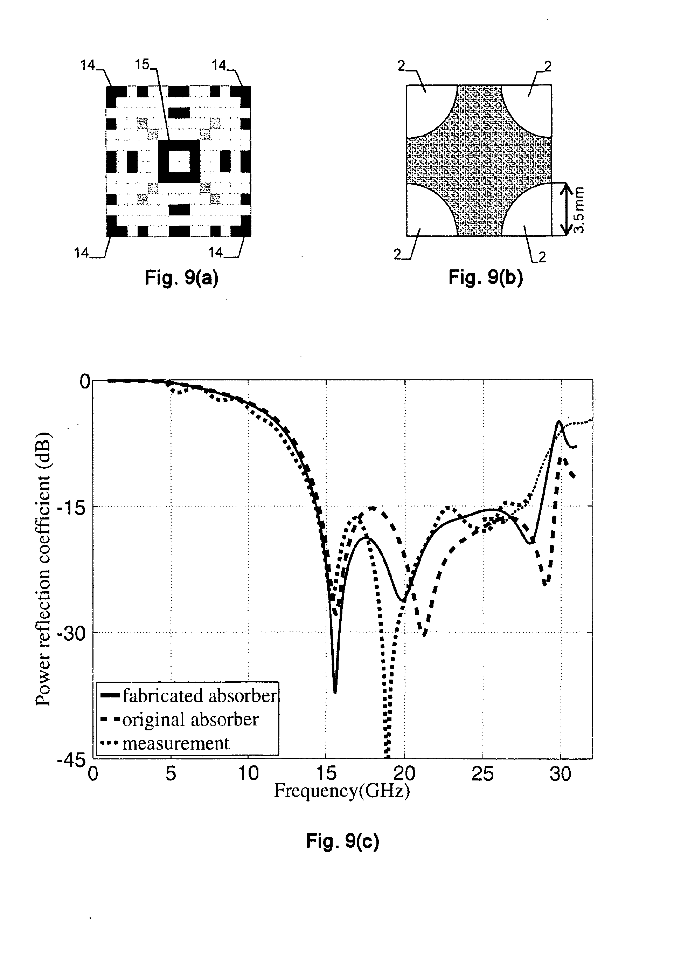

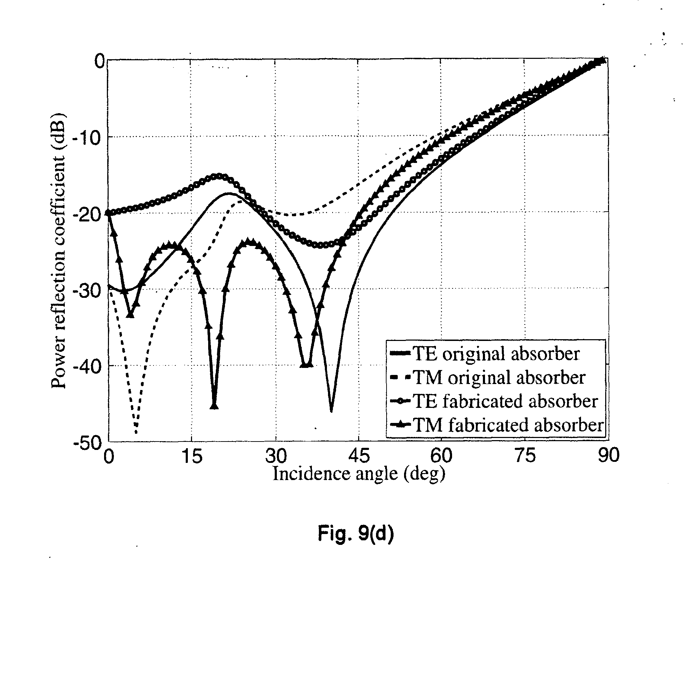

Two absorbers were selected from those of Table I for fabrication; first, the FSS absorber with $R_l$ = 15 dB and homogenous, i.e. non-perforated substrate, second the absorber with perforated substrate, again with $R_l$ = 15 dB, namely the absorber with one opening per unit cell. The unit cell geometry as well as the simulation and measurement results for each absorber are illustrated in Figs. 8 and 9. The simulation results are presented in two groups, namely the reflection curve computed with and without lossless carrier layer 10 covering substrate 1. They are designated in the figures as the "fabricated" and the "original" absorber, respectively.

As seen from the curves in Figs. 8(b) and (c), the thin lossless carrier layer 10 has a small effect on the absorption properties. Thus, optimizing without assuming carrier layer 10 seems reasonable. A fairly good agreement is observed between the results. An important source of error in the measurements is a thin glue layer between first metallic layer 4 and lossy substrate 1. As mentioned before, since the absorbers are resonating structures this small perturbation can incur tangible distortions in the reflection properties. Measurement of the oblique incidence needed a larger anechoic chamber than the available one. Hence, measurements are only accomplished for normal incidence. The obtained bandwidth based on the simulation results is $\Delta f$ = 6.85GHz with $f_c$ = 15.42GHz as the center frequency, and from the measurements we obtain $\Delta f$ = 6.61GHz with $f_c$ = 15.07GHz.

In Fig. 9(a), there are some gray areas shown in the unit cell of first metallic layer 4. The optimum result indeed included these patches. However, they cause difficulties in the fabrication process since they are placed in close proximity without being electrically connected. In addition, omitting these patches decreases the normalized bandwidth by a negligible value (from 0.5033 to 0.4983). Therefore, the manufactured absorber does not contain the gray patches in Fig. 9(a).

From Fig. 9(c) and (d), it is observed that the carrier layer 10 has a higher impact on the performance compared to the unperforated absorber of Fig. 8. The reason is mainly the low average permittivity and permeability of the substrate, which makes it sensitive to the small changes in the upper medium. This pushes the operation frequency to larger values where the thin layer becomes significant. Nonetheless, the differences are small enough to neglect the covering layer in the optimization. Otherwise, the simulation cost would increase and the optimization would take a longer. Note that there are two curves showing the measurement results in Fig. 9(c), which are obtained using two different horn antennas designed for different frequency bands - with some overlap around 27GHz. The curves in Fig. 9(d) are both sketched in the frequency f = 21.2GHz which is the operating frequency of the original absorber.

The obtained bandwidth from the simulation results is $\Delta f$ = 14.4GHz with the center frequency $f_c$ = 21.5GHz and from the measurements $\Delta f$ = 13.1 GHz with $f_c$ = 21 GHz. Compared to the results for the absorber of Fig. 8, a 100% improvement in the bandwidth and 50% enhancement in the relative bandwidth are observed. From the reflection spectrum it can be seen that the main reason for the large bandwidth is the appearance of additional resonances when substrate 1 is perforated. This is the main reason for achieving better performance when only one opening 2 in the substrate 1 is presumed. Drilling several smaller openings 2 in substrate 1 pushes the resonances to undesired high frequencies. As a consequence, the absorber can hardly benefit from additional resonances in this case.

Also, in order to obtain a broad range of resonances, it is advantageous to provide the first metallic layer with first metallic structures (denoted in Fig. 9(a) by reference number 14) arranged vertically over one of the recesses or openings 2 and second metallic structures (reference number 15) not arranged over the recesses or openings 2 but rather over the solid bulk of substrate 1.

In terms of angular stability, the reflected power from the designed absorber at the frequency with maximum absorption remains lower than -15 dB for the incidence angles smaller than 50˚. In case of the absorber with perforated substrate 1, this interval calculated at the center frequency is $\theta < 52˚$. Hence, despite the possibility to reach structures with higher angular stability, this factor remains almost unchanged. The reason is mainly the constraint introduced to the optimizer that makes the bandwidth a more important issue than the angular stability.

V. Conclusions and Notes

A procedure for designing and manufacturing planar radar absorbers based on FSS technology is presented and discussed. The idea of employing perforated substrates for FSS absorbers is investigated as well. To this end, two types of absorbers, "FSS absorbers" and "perforated FSS absorbers", have been studied.

The.design procedure comprised the following four steps:

(1) For absorbers with homogenous (unperforated) substrate 1 MoM and for absorbers with perforated substrate I MoM/TL codes are chosen to analyze each test case.
(2) The RHC (binary hill climbing with random restart) optimizer is selected for all optimizations.
(3) The optimization domain is defined for each absorber type. The unit cell of first metallic layer 4 is subdivided into pixels on a regular grid and the pixels to be metalized are found by the optimizer. For the absorber with perforated substrate, two choices are considered; first including one hole per unit cell and optimizing its radius and second assuming several holes per unit cell and optimizing their positions. It was shown that the first assumption can lead to better performance.
(4) A fitness function should be defined based on the desired specifications of the absorber, which depends on its application.

The optimization results show that absorption properties of the absorber can be strongly enhanced by using one opening per unit cell in substrate 1. In the design example considered above, a 100% improvement of the bandwidth was observed while the angular stability is remained nearly unchanged.

References:

[1] W. H. Emerson, "Electromagnetic wave absorbers and anechoic chambers through the years," Antennas and Propagation, IEEE Transactions on, vol. 23, no. 4, pp.484-490, 1973.
[2] E. F. Knott, J. F. Shaeffer, and M. T. Tuley, Radar Cross Section. Dedham, MA: Artech House, 1985.
[3] O. Bucci and G. Franceschetti, "Scattering from wedge-tapered absorbers," Antennas and Propagation. IEEE Transactions on, vol. 19, no. 1, pp. 96-104, 1971.
[4] B. DeWitt and W. Burnside, "Electromagnetic scattering by pyramidal and wedge absorber," Antennas and Propagation, IEEE Transactions on, vol. 36, no. 7, pp. 971-984, 1988.
[5] A. N. Yusoff and M. H. Abdullah, "Microwave electromagnetic and absorption properties of some LiZn ferrites," Journal of Magnetism and Magnetic Materials, vol. 269, no. 2, pp. 271-280, 2004.
[6] W. W. Salisbury, "Absorbent body for electromagnetic waves," U.S. Patent 2 599 944, 10, 1952.
[7] R. Fante and M. McCormack, "Reflection properties of the salisbury screen," Antennas and Propagation, IEEE Transactions on, vol. 36, no. 10, pp. 1443-1454, 1988.
[8] L. Du Toit and J. Cloete, "Electric screen jauman absorber design algorithms," Microwave Theory and Techniques, IEEE Transactions on, vol. 44, no. 12, pp. 2238-2245, 1996.
[9] B. A. Munk, Frequency Selective Surfaces Theory and Design. New York, NY: John Wiley and Sons, 2000.
[10] N. Engheta, "Thin absorbing screens using metamaterial surfaces," in Proc. IEEE Antennas and Propagation Society Int. Symp., San Antonio, TX, 2002, pp. 392-395.
[11] D. J. Kern and D. H. Werner, "A genetic algorithm approach to the design of ultra-thin electromagnetic bandgap absorbers," Microwave and optical technology letters, vol. 38, no. 1, pp. 61-64, May 2003.
[12] ——, "Magnetic loading of EBG AMC ground planes and ultrathin absorbers for improved bandwidth performance and reduced size," Microwave and Optical Technology Letters, vol. 48, no. 12, pp. 2468-2471, Dec. 2006.
[13] S. Cui, D. Weile, and J. Volakis, "Novel planar electromagnetic absorber designs using genetic algorithms," Antennas and Propagation. IEEE Transactions on Vol. 54, no. 6, pp. 1811-1817, 2006.

[14] A. Fallahi, M. Mishrikey, C. Hafner, and R. Vahldieck, "Analysis of multilayer frequency selective surfaces on periodic and anisotropic substrates," Metamaterials, vol. 3, no. 2, pp. 63-74, Oct. 2009.

[15] T. K. Wu, Ed., Frequency Selective Surface and Grid Array. New York, NY: John Wiley and Sons, 1995.

[16] C. Chan and R. Mittra, "On the analysis of frequency-selective surfaces using subdomain basis functions," Antennas and Propagation, IEEE Transactions on, vol. 38, no. I, pp. 40-50, Jan. 1990.

[17] M. Bozzi and L. Perregrini, "Analysis of multilayered printed frequency selective surfaces by the MoM/BI-RME method," Antennas and Propagation, IEEE Transactions on, vol. 51, no. 10, pp. 2830-2836, Oct. 2003.

[18] E. Miller, "Model-based parameter estimation in electromagnetics. i. background and theoretical development," Antennas and Propagation Magazine. IEEE, vol. 40, no. 1, pp. 42-52, Feb. 1998.

[19] A. Fallahi, M. Mishrikey, C. Hafner, and R. Vahldieck, "Efficient procedures for the optimization of frequency selective surfaces," Antennas and Propagation, IEEE Transactions on, vol. 56, no. 5, pp. 1340-1349, May 2008.

[20] A. M. Nicolson and G. F. Ross, "Measurement of the intrinsic properties of materials by time-domain techniques," Instrumentation and Measurement, IEEE Transactions on, vol. 19, no. 4, pp. 377-382, 1970.

[21] W. Weir, "Automatic measurement of complex dielectric constant and permeability at microwave frequencies," Proceedings of the IEEE, vol. 62, no. 1, pp. 33-36, 1974.

[22] J. Williams, H. Delgado, and S. Long, "An antenna pattern measurement technique for eliminating the fields scattered from the edges of a finite ground plane," Antennas and Propagation, IEEE Transactions on, vol. 38, no. 11, pp. 1815-1822, 1990.

## Claims

1. An absorber for electromagnetic radiation comprising a lossy substrate (1), a first, structured metallic layer (4) arranged on a first side (3) of the substrate (1) and a second metallic layer (6) arranged on a second side (5) of the substrate (1), **characterized in that** a plurality of openings or recesses (2, 7) is arranged in said substrate (1).

2. The absorber of claim 1 wherein said openings or recesses (2, 7) in said substrate (I) are arranged at regular intervals.

3. The absorber of any of the preceding claims wherein said openings or recesses (2, 7) in said substrate (1) have circular cross section.

4. The absorber of any of the preceding claims wherein said first metallic layer (4) has a lattice structure that is periodic along two dimensions with a geometry built from identical lattice unit cells, wherein each unit cell covers an identical arrangement of openings or recesses (2, 7).

5. The absorber of claim 4 wherein there is one opening or recess (2, 7) for each unit cell.

6. The absorber of any of the preceding claims wherein said first metallic layer (4) comprises first metallic structures (14) arranged over one of said openings or recesses (2, 7) and second metallic structures (15) not arranged over said openings or recesses (2, 7).

7. The absorber of any of the preceding claims further comprising a lossless carrier layer (10), wherein said first metallic layer (4) is arranged on a surface of said carrier layer (10), and in particular wherein said carrier layer has a thickness of at least 100 $\mu$m.

8. The absorber of claim 7 wherein said first metallic layer (4) is arranged between said carrier layer (10) and said substrate (1).

9. The absorber of any of the preceding claims wherein said openings (2) extend through said substrate (1).

10. The absorber of any of the preceding claims wherein said recesses (7) extend from said first side (3) into said substrate (I).

11. The absorber of any of the preceding claims wherein said substrate (1) has a complex relative permittivity $\varepsilon = \varepsilon' - i\cdot\varepsilon''$ and permeability $\mu = \mu' - i\cdot\mu''$ with $1 > (\varepsilon'' \cdot \mu'') / (\varepsilon' \cdot \mu') > 10^{-2}$.

12. A method for manufacturing the absorber of any of the preceding claims comprising the steps of
providing said substrate (1),

mounting said first metallic layer (4) to said substrate (1) and
mounting said second metallic layer (6) to said substrate (1).

13. The method of claim 12 wherein said first metallic layer (4) is mounted to a surface of a lossless carrier layer (10) and then said carrier layer (10) and said first metallic layer (4) are mounted to said substrate (1).

14. The method of claim 13 wherein said recesses or openings in said substrate (1) are formed prior to mounting said carrier layer (10) and said first metallic layer (4) to said substrate (1).

Fig. 1

(a)

(b)

(c)

Fig. 2

Fig. 3

Fig. 4

**Fig. 5**

**Fig. 6**

**Fig. 7**

**Fig. 8(a)**

Fig. 8(b)

Fig. 8(c)

Fig. 9(a)

Fig. 9(b)

Fig. 9(c)

Fig. 9(d)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FALLAHI A ET AL: "Radar absorbers based on frequency selective surfaces on perforated substrates" JOURNAL OF COMPUTATIONAL AND THEORETICAL NANOSCIENCE APRIL 2008 AMERICAN SCIENTIFIC PUBLISHERS US, vol. 5, no. 4, April 2008 (2008-04), pages 704-710, XP9138869 DOI: DOI:10.1166/JCTN.2008.041 * paragraph [003.]; figures 2,3c,d * ----- | 1-14 | INV. H01Q15/00 H01Q17/00 H05K9/00 |
| X | ARYA FALLAHI ET AL: "MoM/RCWA analysis of frequency selective surfaces with inhomogeneous, periodic substrates" ELECTROMAGNETIC COMPATIBILITY, 2007. EMC ZURICH 2007. 18TH INTERNATION AL ZURICH SYMPOSIUM ON, IEEE, PI, 1 September 2007 (2007-09-01), pages 309-312, XP031164456 ISBN: 978-3-9523286-1-3 * the whole document * ----- | 1-6,9-12 | |
| A,D | FALLAHI A ET AL: "Analysis of multilayer frequency selective surfaces on periodic and anisotropic substrates" METAMATERIALS OCTOBER 2009 ELSEVIER NLD, vol. 3, no. 2, October 2009 (2009-10), pages 63-74, XP002601218 DOI: DOI:10.1016/J.METMAT.2009.04.001 * the whole document * ----- -/-- | 1-14 | TECHNICAL FIELDS SEARCHED (IPC) H01Q H05K |

The present search report has been drawn up for all claims

| Place of search | Date of completion of the search | Examiner |
|---|---|---|
| Munich | 20 September 2010 | Kaleve, Abraham |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 10 00 3849

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FALLAHI A ET AL: "Analysis and optimization of frequency selective surfaces with inhomogeneous periodic substrates"<br>PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA,<br>vol. 6717, no. 1,<br>8 October 2007 (2007-10-08), pages 1-11,<br>XP002601219<br>ISSN: 0277-786X<br>* the whole document *<br>----- | 1-14 | |
| A | CHAKRAVARTY S ET AL: "Application of a microgenetic algorithm (MGA) to the design of broadband microwave absorbers using multiple frequency selective surface screens buried in dielectrics"<br>IEEE TRANSACTIONS ON ANTENNAS AND PROPAGATION IEEE USA,<br>vol. 50, no. 3, March 2002 (2002-03),<br>pages 284-296, XP002601220<br>ISSN: 0018-926X<br>* abstract; figure 5; table IV *<br>----- | 1-14 | TECHNICAL FIELDS SEARCHED (IPC) |
| A | WO 2007/080368 A1 (UNIV SHEFFIELD [GB]; CHAMBERS BARRY [GB]; FORD LEE [GB])<br>19 July 2007 (2007-07-19)<br>* page 5, line 12 - line 26; figure 2 *<br>-----<br><div align="right">-/--</div> | 1-14 | |

The present search report has been drawn up for all claims

| Place of search | Date of completion of the search | Examiner |
|---|---|---|
| Munich | 20 September 2010 | Kaleve, Abraham |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 10 00 3849

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | CUI S ET AL: "Novel planar electromagnetic absorber designs using genetic algorithms" IEEE TRANSACTIONS ON ANTENNAS AND PROPAGATION IEEE USA, vol. 54, no. 6, June 2006 (2006-06), pages 1811-1817, XP002601221 ISSN: 0018-926X * paragraph [0II.]; figures 2,3; table I * ----- | 1-14 | |
| | | | **TECHNICAL FIELDS SEARCHED (IPC)** |

The present search report has been drawn up for all claims

| Place of search | Date of completion of the search | Examiner |
|---|---|---|
| Munich | 20 September 2010 | Kaleve, Abraham |

EPO FORM 1503 03.82 (P04C01)

**ANNEX TO THE EUROPEAN SEARCH REPORT
ON EUROPEAN PATENT APPLICATION NO.**

EP 10 00 3849

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2010

| Patent document cited in search report | Publication date | Patent family member(s) | Publication date |
|---|---|---|---|
| WO 2007080368 A1 | 19-07-2007 | NONE | |

EPO FORM P0459

For more details about this annex : see Official Journal of the European Patent Office, No. 12/82

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

## Patent documents cited in the description

- US 2599944 A

## Non-patent literature cited in the description

- **W. H. EMERSON.** Electromagnetic wave absorbers and anechoic chambers through the years. *Antennas and Propagation, IEEE Transactions on,* 1973, vol. 23 (4), 484-490
- **E. F. KNOTT ; J. F. SHAEFFER ; M. T. TULEY.** Radar Cross Section. Dedham. Artech House, 1985
- **O. BUCCI ; G. FRANCESCHETTI.** Scattering from wedge-tapered absorbers. *Antennas and Propagation. IEEE Transactions on,* 1971, vol. 19 (1), 96-104
- **B. DEWITT ; W. BURNSIDE.** Electromagnetic scattering by pyramidal and wedge absorber. *Antennas and Propagation, IEEE Transactions on,* 1988, vol. 36 (7), 971-984
- **A. N. YUSOFF ; M. H. ABDULLAH.** Microwave electromagnetic and absorption properties of some LiZn ferrites. *Journal of Magnetism and Magnetic Materials,* 2004, vol. 269 (2), 271-280
- **R. FANTE ; M. MCCORMACK.** Reflection properties of the salisbury screen. *Antennas and Propagation, IEEE Transactions on,* 1988, vol. 36 (10), 1443-1454
- **L. DU TOIT ; J. CLOETE.** Electric screen jauman absorber design algorithms. *Microwave Theory and Techniques, IEEE Transactions on,* 1996, vol. 44 (12), 2238-2245
- **B. A. MUNK.** Frequency Selective Surfaces Theory and Design. John Wiley and Sons, 2000
- **N. ENGHETA.** Thin absorbing screens using metamaterial surfaces. *Proc. IEEE Antennas and Propagation Society Int. Symp.,* 2002, 392-395
- **D. J. KERN ; D. H. WERNER.** A genetic algorithm approach to the design of ultra-thin electromagnetic bandgap absorbers. *Microwave and optical technology letters,* May 2003, vol. 38 (1), 61-64
- Magnetic loading of EBG AMC ground planes and ultrathin absorbers for improved bandwidth performance and reduced size. *Microwave and Optical Technology Letters,* December 2006, vol. 48 (12), 2468-2471

- **S. CUI ; D. WEILE ; J. VOLAKIS.** Novel planar electromagnetic absorber designs using genetic algorithms. *Antennas and Propagation. IEEE Transactions on,* 2006, vol. 54 (6), 1811-1817
- **A. FALLAHI ; M. MISHRIKEY ; C. HAFNER ; R. VAHLDIECK.** Analysis of multilayer frequency selective surfaces on periodic and anisotropic substrates. *Metamaterials,* October 2009, vol. 3 (2), 63-74
- Frequency Selective Surface and Grid Array. John Wiley and Sons, 1995
- **C. CHAN ; R. MITTRA.** On the analysis of frequency-selective surfaces using subdomain basis functions. *Antennas and Propagation, IEEE Transactions on,* January 1990, vol. 38 (I), 40-50
- **M. BOZZI ; L. PERREGRINI.** Analysis of multilayered printed frequency selective surfaces by the MoM/BI-RME method. *Antennas and Propagation, IEEE Transactions on,* October 2003, vol. 51 (10), 2830-2836
- **E. MILLER.** Model-based parameter estimation in electromagnetics. i. background and theoretical development. *Antennas and Propagation Magazine. IEEE,* February 1998, vol. 40 (1), 42-52
- **A. FALLAHI ; M. MISHRIKEY ; C. HAFNER ; R. VAHLDIECK.** Efficient procedures for the optimization of frequency selective surfaces. *Antennas and Propagation, IEEE Transactions on,* May 2008, vol. 56 (5), 1340-1349
- **A. M. NICOLSON ; G. F. ROSS.** Measurement of the intrinsic properties of materials by time-domain techniques. *Instrumentation and Measurement, IEEE Transactions on,* 1970, vol. 19 (4), 377-382
- **W. WEIR.** Automatic measurement of complex dielectric constant and permeability at microwave frequencies. *Proceedings of the IEEE,* 1974, vol. 62 (1), 33-36
- **J. WILLIAMS ; H. DELGADO ; S. LONG.** An antenna pattern measurement technique for eliminating the fields scattered from the edges of a finite ground plane. *Antennas and Propagation, IEEE Transactions on,* 1990, vol. 38 (11), 1815-1822